Europäisches Patentamt

European Patent Office

Office européen des brevets

(19)

(11) Veröffentlichungsnummer: **0 219 627 B1**

# (12) EUROPÄISCHE PATENTSCHRIFT

(45) Veröffentlichungstag der Patentschrift:
**05.06.91 Patentblatt 91/23**

(51) Int. Cl.$^5$: **H01L 23/52, H01L 23/14**

(21) Anmeldenummer: **86110664.9**

(22) Anmeldetag: **01.08.86**

(54) **Mehrschichtige gedruckte Schaltungsplatte.**

(30) Priorität: **24.09.85 CH 4122/85**

(43) Veröffentlichungstag der Anmeldung:
**29.04.87 Patentblatt 87/18**

(45) Bekanntmachung des Hinweises auf die
Patenterteilung:
**05.06.91 Patentblatt 91/23**

(84) Benannte Vertragsstaaten:
**CH DE FR GB IT LI NL SE**

(56) Entgegenhaltungen:
**WO-A-84/04441**
**FR-A- 2 404 990**
**FR-A- 2 529 386**

(56) Entgegenhaltungen:
**GB-A- 2 136 205**
**IBM TECHNICAL DISCLOSURE BULLETIN,**
**Band 23, Nr. 1, Juni 1980, Seiten 374-377, New**
**York, US; E.F. MIERSCH et al.: "High speed**
**metal carrier packaging system using thin-film**
**interconnection techniques"**
**PATENTS ABSTRACTS OF JAPAN, Band 5, Nr.**
**142 (P-79)[814], 8. September 1981; & JP-A-56**
**77 990 (NIPPON DENKI K.K.) 26-06-1981**

(73) Patentinhaber: **Oerlikon-Contraves AG**
**Schaffhauserstrasse 580**
**CH-8052 Zürich (CH)**

(72) Erfinder: **Elsener, Josef**
**Anton Higistrasse 8**
**CH-8046 Zürich (CH)**

**Beschreibung**

Die Erfindung betrifft eine mehrschichtige gedruckte Schaltungsplatte mit elektronischen Bauelementen, insbesondere integrierten Halbleiter- und/oder Hybridbauelementen.

Bei den dem Fachmann allgemein bekannten Schaltungsplatten dieser Art sind die Halbleiterbauelemente jeweils in einem mit einem Gehäuserahmen, einem Bodenteil und einem Verschlussdeckel versehenen Gehäuse eingeschlossen, das als Ganzes auf der Schaltungsplatte montiert wird, wobei die zahlreichen Verbindungen von den Bauelementen nach den aussen am Gehäuse zugänglichen Anschlussstellen über frei tragende Verbindungsdrähte (Bonddrähte) vom Bauelement zu den durch den Gehäuserahmen geführten Leiterstücken gebildet werden.

Oft wird dabei angestrebt, das Bauelement auf einer gut wärmeleitenden Schicht zu befestigen und über Bonddrähte mit den Leiterbahnen eines Substrats zu verbinden. Die WO-A-8404441 zeigt Details einer derartigen Anordnung mit dem Bauelement in einer Ausnehmung des Substrats, welch letzteres überdies weitergehende Verbindungsfunktionen übernimmt.

Die GB-A-2136205 beschreibt ein Gehäuse mit einer in den Boden eingelassenen Wärmesenke, auf der das Halbleiterbauelement befestigt wird, mehrlagigen Leiterverbindungen mit einer Aussparung für das Bauelement und Kontaktstellen zum Anschluss desselben über Bonddrähte, Verbindungen zu den nach aussen geführten Anschlussstiften sowie dem Gehäusedeckel. Des Aufban kann mit Platinen, wie sie bei der Herstellung dedruckter Schaltungen eingesekt werden, erfolgen, so daß dieses gehäuse, welches zudem ebenfalls verbindungsfunktionen übernimmt, die Merkmale einer Schaltungsplatte gemäß Oberbegriff des Patentanspruchs 1 aufweist.

Zur Integration der Bauelemente in einem grösseren Verbund werden die Gehäuse auf der Oberseite einer beispielsweise mehrere Leiterschichten aufweisenden Leiterplatte an vorgegebenen Stellen befestigt, wobei ihre äusseren Leiterstücke mit den vorgesehenen Leitern der Schaltungsplatte verlötet werden. Die Wärmeabfuhr von der Wärmesenke der Gehäuse, wie in der GB-A-2136205 angegeben, geschieht dabei an der der Schaltungsplatte abgewandten Seite des Gehäuses durch Konvektion und Strahlung. Soll eine zusätzliche Ableitung über die Schaltungsplatte erfolgen, müssen auf der Schaltungsplatte im Bereich der Gehäuse wärmeleitende Gebiete ausgeschieden werden, die dann nicht mehr für Verbindungen zur Verfügung stehen, was die mögliche Packungsdichte reduziert.

Der Erfindung liegt die Aufgabe zugrunde, eine Schaltungsplatte zu entwickeln, die eine höhere Packungsdichte der Bauelemente sowie eine verbesserte Wärmeableitung von den Bauelementen ermöglicht. Die Lösung dieser Aufgabe erfolgt aufgrund der kennzeichnenden Merkmale des Patentanspruchs 1.

Im folgenden wird die Erfindung anhand eines in grösserem Massstab dargestellten Einführungsbeispiels näher erläutert.

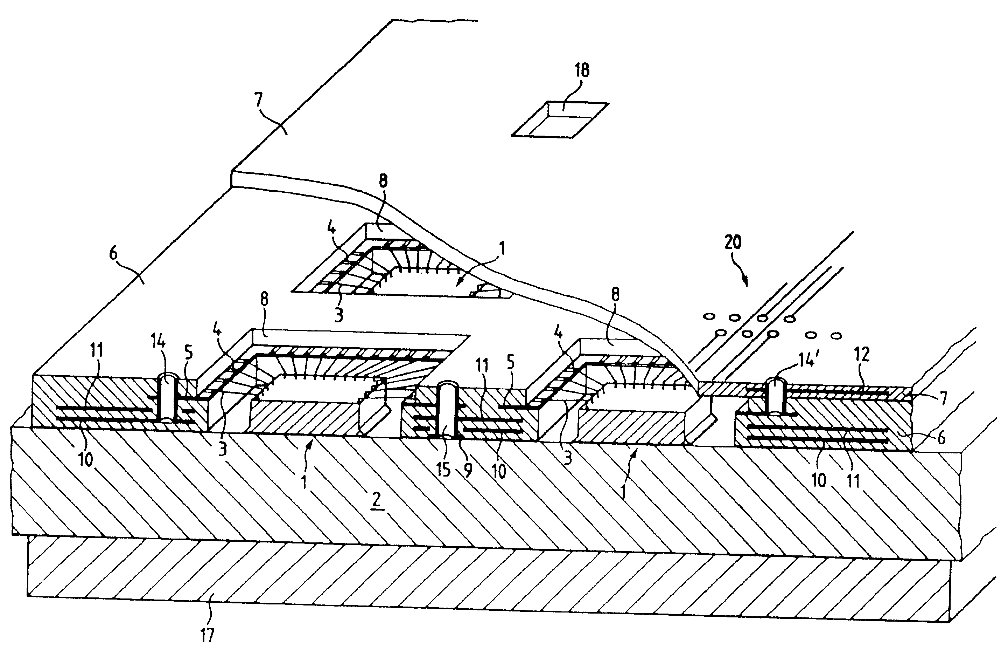

Die Zeichnung zeigt einen Eckbereich einer Schaltungsplatte in perspektivischer schematischer Darstellung, teilweise im Schnitt und mit einem aus Darstellungsgründen weggebrochenen Teil einer verschliessenden Leiterplatte.

Die mit 1 bezeichneten Halbleiterbauelemente haben im Gegensatz zu solchen, die an bekannten Schaltungsplatten vorgesehen sind, kein eigenes Gehäuse sondern entsprechen ungehäusten, aktiven oder passiven elektronischen Komponenten. Dies ermöglicht ihre unmittelbare Befestigung (Klebebefestigung) auf einer dem Wärmeausgleich und der Wärmeableitung dienenden metallischen Trägerplatte 2, so dass sie wesentlich besser, durch direkte Wärmeableitung an die Trägerplatte 2, gekühlt werden. Da die elektronischen Halbleiterbauelemente 1 direkt mit Anschlussleitern 3 an Leiter 4 einer Speiseleiterschicht 5 ohne Zwischenhaltung eines jeweiligen Gehäuserahmens angebonded sind, haben sie einen geringen Platzbedarf, so dass sie in relativ hoher Packungsdichte nebeneinander auf der Trägerplatte 2 angeordnet und befestigt werden können.

Zur Bildung eines Ersatzgehäuses aus mindestens zwei Leiterplatten 6,7 zusammen mit der Trägerplatte 2, sind in der mittleren, als Speiseleiterplatte ausgebildeten Leiterplatte 6 fensterartige Aufnahmeöffnungen 8 für die Halbleiterbauelemente 1 vorgesehen, welche durch die die erste Leiterplatte 6 überdeckende, als Verbindungsleiterplatte vorgesehene, zweite Leiterplatte 7 verschlossen sind.

Die durch die fensterartigen Aufnahmeöffnungen 8 in der ersten Leiterplatte 6 entfallenden Leiterbahnen sind stattdessen in der zweiten Leiterplatte 7 vorgesehen. Die elektrischen Verbindungen zwischen den verschiedenen in der ersten Leiterplatte 6 und der zweiten Leiterplatte 7 in mehreren übereinander liegenden Ebenen vorgesehenen Leiterschichten 9 bis 12 werden mittels durchmetallisierter Verbindungs- und/oder Sacklochbohrungen 14, 14′,15 an schaltungsspezifischen, d.h. geeigneten Stellen, auf an sich bekannte Weise erreicht. Ein Teil beispielsweise in üblicher Aetztechnik auf der Deckschicht der zweiten Leiterplatte 7 vorgesehener, weiterer Leitungsmuster ist durch den mit 20 bezeichneten Bereich schematisch angedeutet.

Auf der gegenüberliegenden Seite der beispielsweise aus Aluminium bestehenden Trägerplatte 2 können ebenfalls Halbleiterbauelemente 1 auf gleiche Weise, wie vorstehend beschrieben in fensterartigen Aufnahmeöffnungen direkt auf der Trägerplatte 2 befestigt sein. Die bei diesem Beispiel bereits miteinander verklebten und schematisch dargestellten Leiterplatten auf dieser anderen Trägerplattenseite sind in ihrer Gesamtheit mit 17 bezeichnet.

Die Dicke der ersten Leiterplatte 6 liegt in der Grössenordnung von O,8mm bis 1,2mm unter Einschluss der entsprechenden Leiterschichten und ist grösser als die Dicke der Halbleiterbauelemente 1. Die nur eine Leiterschicht 12 einschliessende zweite Leiterplatte 7, die auch als Verbindungs- oder Verschlussplatte dient, hat z.B. eine Dicke von 0,5 mm. Die Leiterschichten und das sie umschliessende Kunststoffmaterial entsprechen den für Leiterplatten üblichen Materialien. In der überdeckenden Leiterplatte 7 können transparente Bereiche 18, z.B. für das Löschen von EPROM'S (Eraseable Programmable Read Only Memory) vorgesehen sein. Weiterhin kann die zweite Leiterplatte 7 auch als Trägerteil für weitere, nicht näher dargestellte SMD-Bauelemente (Surface Mounted Device) dienen.

Neben den Vorteilen einer bestmöglichen Wärmeableitung von den elektronischen Bauelementen 1 über die Trägerplatte 2 und der wesentlich erhöhbaren Dichte ihrer Anordnung nebeneinander, ergeben sich aufgrund der Erfindung zahlreiche weitere Vorteile. Für die Herstellung der Schaltungsplatte sind, ausgehend von den gehäuselosen IC-Chips weniger Fertigungsschritte erforderlich. Aufgrund der Vermeidung individueller Gehäuse mit Gehäuserahmen, durch die die elektrischen Anschlüsse hindurchgeführt sind, ergibt sich eine erhebliche Verringerung der Anzahl von herzustellenden elektrischen Verbindungen mit entsprechend verbesserter Zuverlässigkeit. Die Zuverlässigkeit wird weiterhin durch die bessere Beherrschbarkeit unterschiedlicher Wärmedehnungen zwischen den Bauelementen 1 und der Trägerplatte 2 erhöht. Bei dem Entwurf der Schaltungen ergibt sich eine Vereinfachung, da nicht verschiedene Gehäusebauformen von Bauelementen berücksichtigt werden müssen.

## Ansprüche

1. Mehrschichtige gedruckte Schaltungsplatte mit einer wärmeableitenden Trägerplatte (2), einer darauf befestigten, mehrlagige Leiterverbindungen (10, 11) enthaltenden, ersten Leiterplatte (6), die fensterartige, bis auf die Trägerplatte (2) reichende Aufnahmeöffnungen (8) aufweist, mit integrierten, elektronischen Bauelementen (1) ohne Gehäuse, die in diesen Aufnahmeöffnungen (8) direkt auf der Trägerplatte (2) befestigt und über Bonddrähte (3) mit Leiterbahnen (4) der ersten Leiterplatte (6) verbunden sind, gekennzeichnet durch eine mindestens einlagige Leiterverbindungen (12, 20) aufweisende zweite Leiterplatte (7), die über der ersten Leiterplatte (6) liegt, mit dieser elektrisch und mechanisch verbunden ist und die elektronischen Bauelemente (1) gehäuseartig abschliesst.

2. Schaltungsplatte nach Anspruch 1, wobei die zweite Leiterplatte (7) an der Deckschicht ein Leitungsmuster (20) aufweist und als Träger für oberflächenmontierte Bauelemente ausgebildet ist.

3. Schaltungsplatte nach Anspruch 1 oder 2, gekennzeichnet durch transparente Bereiche (18) in der zweiten Leiterplatte (7) über den Aufnahmeöffnungen (8) in der ersten Leiterplatte (6).

4. Schaltungsplatte nach einem der Ansprüche 1 bis 3, gekennzeichnet durch einen gleichartigen Aufbau beidseits der Trägerplatte (2).

## Claims

1. Multilayer printed circuit board having a heat-removing carrier plate (2), a first printed circuit board (6) which is secured thereto, contains multiple-layer conductor connections (10, 11) and has window-like receiving openings (8) which reach as far as the carrier plate (2), having integrated, electronic components (1) without housings, which components are secured, in these receiving openings (8), directly to the carrier plate (2) and are connected by way of bond wires (3) with printed conductors (4) of the first printed circuit board (6), characterised by a second printed circuit board (7) which has at least single-layer conductor connections (12, 20), lies above the first printed circuit board (6), is electrically and mechanically connected with the latter and encloses the electronic components (1) in a housing-like manner.

2. Circuit board according to claim 1, in which the second printed circuit board (7) has a conductor pattern (20) on the outer layer and is formed as a carrier for surface-mounted components.

3. Circuit board according to claim 1 or 2, characterised by transparent areas (18) in the second printed circuit board (7) above the receiving openings (8) in the first printed circuit board (6).

4. Circuit board according to one of the claims 1 to 3, characterised by a similar structure on both sides of the carrier plate (2).

## Revendications

1. Panneau de circuit imprimé à multicouches comprenant un panneau de support (2) pour l'évacuation de la chaleur, un premier panneau de circuit (6) fixé sur le panneau de support et comportant des liaisons conductrices (10, 11) en plusieurs couches, panneau de circuit présentant des logements (8) en forme de fenêtres arrivant jusque sur le panneau de support (2), avec des composants électroniques (1) intégrés, sans boîtier, qui sont fixés directement sur le panneau de support (2) dans les logements (8) et sont reliés par des fils conducteurs de liaison (3) aux chemins conducteurs (4) du premier panneau de circuit (6), panneau caractérisé par un second panneau de circuit (7) comportant des liaisons conductrices (12, 20) à au moins une couche, ce second panneau étant placé par-dessus le premier panneau de circuit (6) en étant relié mécaniquement et électriquement à celui-ci et enfermant les composants électroniques (1) à la manière de boîtier.

2. Panneau de circuit imprimé selon la revendication 1, caractérisé en ce que le second panneau de circuit (7) présente sur sa couche supérieure un modèle de chemin conducteur (20) et est réalisé comme support pour les composants montés en surface.

3. Panneau de circuit imprimé selon la revendication 1 ou 2, caractérisé par des zones transparentes (18) dans le second panneau de circuit (7) au-dessus des logements (8) du premier de panneau de circuit (6).

4. Panneau de circuit imprimé selon l'une des revendications 1 à 3, caractérisé en ce qu'il présente la même construction des deux côtés du panneau de support (2).

EP 0 219 627 B1